# EUROPEAN PATENT APPLICATION

(11) **EP 1 770 780 A2**
(43) Date of publication of application: **04.04.2007**
(21) Application number: 06117373.8
(22) Date of filing: 18.07.2006
(51) Int. Cl.: H01L 27/146

(54) **Solid-State Image Pickup Device**

(30) Priority: 28.09.2005 JP 2005282010
(71) Applicant: MATSUSHITA ELECTRIC INDUSTRIAL CO., LTD., Kadoma-shi, Osaka 571-8501 (JP)
(72) Inventor: Ohta, Sougo, Osaka Osaka 540-6319 (JP)
(74) Representative: Grünecker, Kinkeldey, Stockmair & Schwanhäusser Anwaltssozietät

(57) **Abstract**

Provided is a solid-state image pickup device which comprises well contacts and well wirings for supplying a reference voltage to a well and can suppress a reduction in an amount of light received even when a pixel area is decreased. As a well wiring, used is a well main-wiring (4) which is formed in a same process as that in which gates of respective transistors are formed, using a same material as that of the gates of respective transistors. In a pixel region (PXR), the well wiring and the well contact comprises the well main-wiring (4), a well sub-wiring (6) in a first wiring layer (10) immediatelyabove thewellmain-wiring (4), contacts (3 and 5) provided in a gate electrode layer (9). The well wiring and the well contact are not formed in wiring layers above a second wiring layer (11).

## Description

### BACKGROUND OF THE INVENTION

### Field of the Invention

The present invention relates to a solid-state image pickup device which is capable of controlling a voltage supplied to a well in a pixel region.

### Description of the Background Art

A demand for increasing a number of pixels in a solid-state image pickup device which is typically MOS-type or CCD-type remains great and nowadays a consumer digital camera which attains eight mega or more pixels has emerged. Although an image having higher resolution can be obtained by increasing the number of pixels, a problem of "shading" accrues. "Shading" occurs due to varying pixel sensitivity depending on a position of a pixel among pixels disposed in a pixel region PXR in a matrix manner. The pixel sensitivity varies in each concentric region in the pixel region PXR as a position of a pixel is distanced from a center of the pixel region PXR to a periphery of the pixel region PXR.

The shading arises when a voltage applied to a well formed on a semiconductor substrate varies in the each concentric region in the pixel region PXR. In particular, when a number of pixels disposed in a vertical direction exceeds 2,000, influence caused by the varying voltage applied to the well appears in a shot image apparently (refer to Japanese Laid-Open Patent Publication No. 2001-230400).

FIG. 15 is a diagram disclosed in Japanese Laid-Open Patent Publication No.2001-230400and shows a relationship between a voltage applied to the well and control timing of a selection transistor, an N signal transfer switch, and a (S+N) signal transfer switch. A dotted line shows a voltage applied to the well at a center position A of the pixel region PXR, a chain double-dashed line shows a voltage applied to the well at a position B outside of the position A, and a continuous line shows a voltage applied to the well at a position C of a peripheral circuitry region PPR. In this figure, it can be found that the nearer a position of a pixel comes to the center of the pixel region PXR, the higher a voltage applied to the well at a rise time and the longer a period of time required for the voltage to be settled in a steady state become. In this document, it is disclosed that the shading is suppressed through providing a contact, for supplying a reference voltage Vw (ground potential), in the well within each pixel and maintaining a voltage applied to the well in a constant manner at any position.

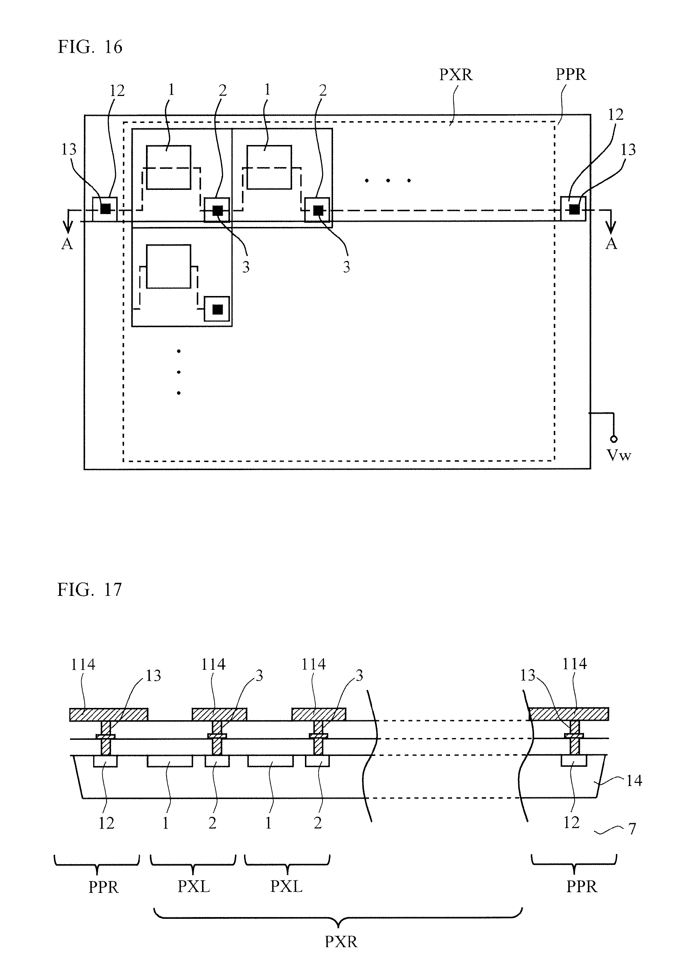

FIG. 16 is a schematic plane diagram illustrating a solid-state image pickup device in which well contacts 3 are provided in the pixel region PXR and the peripheral circuitry region PPR. FIG. 17 is a diagram illustrating a cross-sectional view of a conventional solid-state image pickup device along a line A-A shown in FIG. 16. Light receiving regions of photodiodes 1 (hereinafter, referred to as PD 1) and doped regions 2 are formed by implanting and diffusing N-type impurity and P-type impurity in a well 14 which is formed by implanting and diffusing P-type impurity on a surface of a semiconductor substrate 7. A reference voltage Vw (ground voltage) is supplied via well wirings 114 and contacts 3 to the doped regions 2. Thus, the voltage applied to the well is controlled so as to be constant irrespective of a position in the pixel region, whereby an image having the shading suppressed and having a fine quality can be obtained.

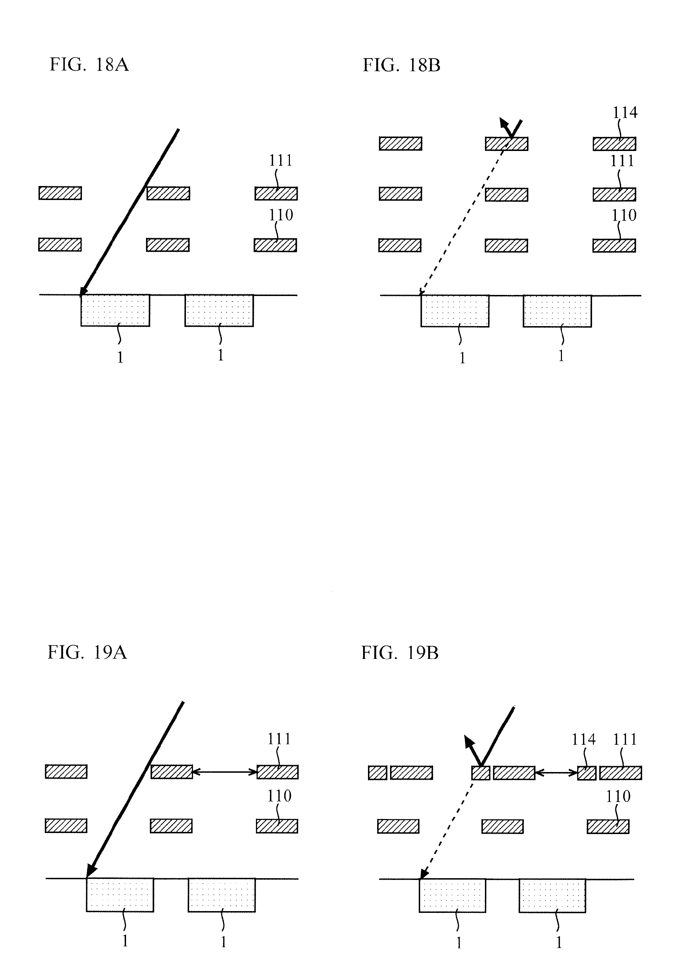

However, as shown in FIG. 17, because the well wirings 114 are provided in an uppermost wiring layer of the conventional solid-state image pickup device, a following problem arises. Downsizing and sensitivity improvement of the solid-state image pickup device have been strongly demanded. In order to meet these demands, it is required to design pixels so as to reduce an area of a pixel and to ensure a large amount of light received as much as possible. As is seen by comparing FIGs. 18A and 18B, when a number of wiring layers is increased to 3 layers (FIG. 18B) in order to provide the well wirings 114, from two layers (wirings 110 and 111 in FIG. 18A) in a case where the well wirings 114 are not provided, an amount of incident light into PD 1 decreases. And as is seen by comparing FIGs. 19A and 19B, even if the number of wiring layers is not increased, when an area of wirings in an uppermost wiring layer increases, the incident light into PD 1 decreases.

### SUMMARY OF THE INVENTION

Therefore, an object of the present invention is to provide a solid-state image pickup device which comprises well contacts and well wirings for supplying a reference voltage to a well and can suppress a reduction in an amount of light received even when a pixel area is decreased.

The solid-state image pickup device according to the present invention includes a pixel region and a peripheral circuitry region on a semiconductor substrate having a well region, which has a first conductive characteristic, formed thereon, comprising: a plurality of photodiodes, which have a second conductive characteristic,providedinthewellregion;a plurality of floating diffusions, which have the second conductive characteristic, provided in the well region; a plurality of transfer gates provided for each of the photodiodes on the semiconductor substrate; and a plurality of well main-wirings formed on a same layer as that on which the transfer gates are formed, wherein a reference voltage is supplied via the well main-wirings from the peripheral circuitry region to the well region within the pixel region.

The pixel region may further comprise: a plurality of well sub-wirings provided in a lowermost metal wiring layer on the semiconductor substrate; a plurality of first contacts for connecting the well main-wirings and the well sub-wirings; and a plurality of second contacts for connecting the well sub-wirings and the well region.

The well region having the first contact connected thereto may further comprise a first conductive doped region.

The peripheral circuitry region may further comprise a plurality of third contacts for connecting the well main-wirings and the well.

Preferably, wirings provided in an uppermost metal wiring layer are connected to the well main-wirings only in the peripheral circuitry region.

Each of the well main-wirings may be provided for each n (n is an even number) rows.

In a MOS-type solid-state image pickup device in which a combination of n pixels adjacent in a column direction share a reset transistor, the well main-wirings may extend on an edge of the combination of the pixels in a column direction.

Each of the second contacts may be provided on a first or nth pixel of n pixels adjacent in a column direction.

The lower a layer where a light beamenters is, the smaller a diameter of the light beam collected by a microlens becomes. Therefore, the lower a layer where a light beam enters is, the wider an area where light does not enter, i.e. , an area of a region where light is not shut out even with a wiring provided, is. In the solid-state image pickup device, as a principal well wiring, a well main-wiring which is formed in a same process as that in which gates of transistors are formed, using a same material as that of the gates of the transistors, is used. The well sub-wirings which are wirings in a lowermost metal wiring layer are used only at portions connecting the well main-wirings and the well. Thus, when the wirings in the lower layers are used, the amount of light received by PD 1 is easily ensured as compared with a case where the well wirings are provided in the upper layers, whereby shading is suppressed and a reduction in the amount of light received can be curbed, attaining a high-quality image. Hence, the solid-state image pickup device according to the present invention comprises the well contacts and the well wirings for supplying the reference voltage to the well and thereby, even when the area of the pixel is decreased, can suppress the reduction in the amount of light received.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a schematic sectional diagram illustrating a solid-state image pickup device according to a first embodiment of the present invention;
FIG. 2 is an example of a circuit diagram illustrating pixels;
FIG. 3 is a schematic sectional diagram of the solid-state image pickup device realizing circuits shown in FIG. 2;
FIG. 4 is another schematic sectional diagram of the solid-state image pickup device realizing the circuits shown in FIG. 2;
FIG. 5 is a diagram illustrating a layout of pixels shown in FIG. 2;
FIG. 6 is a cross-sectional diagram along a line B-B in FIG. 5;
FIG. 7 is a diagram illustrating a layout of a pixel region;
FIG. 8 is a circuit diagram illustrating pixels in a solid-state image pickup device according to a second embodiment of the present invention;
FIG. 9 is a diagram illustrating a layout of the pixels shown in FIG. 8;
FIG. 10 is a diagram illustrating a layout of a pixel region;
FIG. 11 is a circuit diagram illustrating pixels in a solid-state image pickup device according to a third embodiment of the present invention;
FIG. 12 is a diagram illustrating a layout of an pixel region;
FIG. 13 is a circuit diagram illustrating pixels in a solid-state image pickup device according to a fourth embodiment of the present invention;
FIG. 14 is a diagram illustrating a layout of an pixel region;

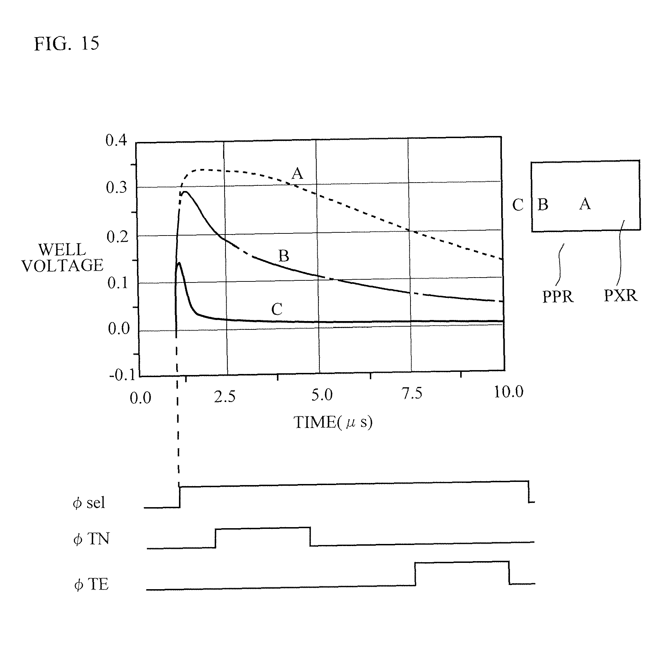

FIG. 15 is a diagram explaining a relationship between a voltage applied to a well at each position within the pixel region and time;
FIG. 16 is a diagram illustrating a pixel region and a peripheral circuitry region;
FIG. 17 is a schematic sectional diagram of a conventional solid-state image pickup device;
FIG. 18A is a diagram explaining a relationship between a number of wiring layers and an amount of light received;
FIG. 18B is a diagram explaining a relationship between a number of wiring layers and an amount of light received;
FIG. 19A is a diagram explaining a relationship between an wiring area and an amount of light received; and
FIG. 19B is a diagram explaining a relationship between an wiring area and an amount of light received.

### DESCRIPTION OF THE PREFERRED EMBODIMENTS

### (first embodiment)

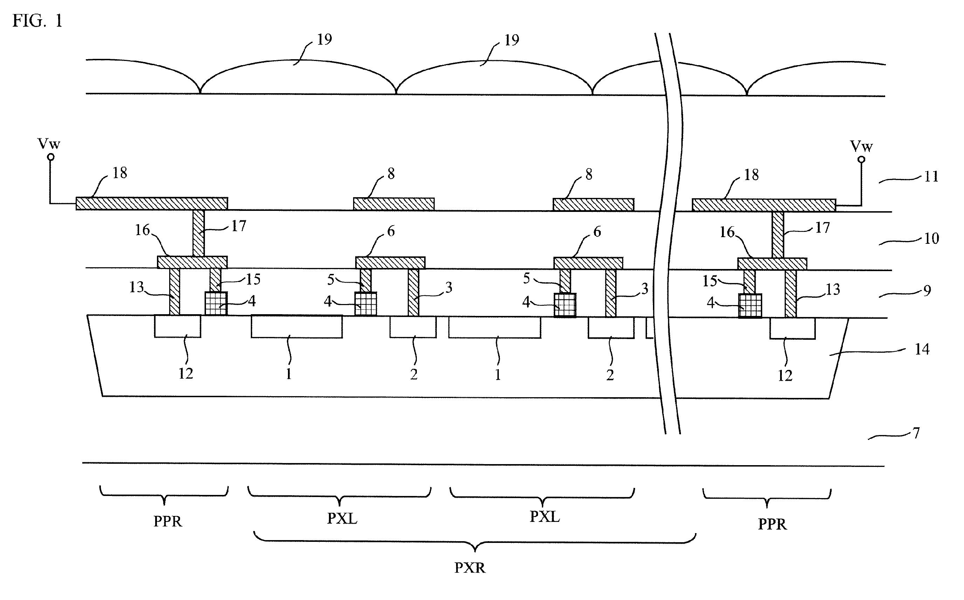

FIG. 1 is a schematic diagram illustrating a cross-sectional view, along a line corresponding a line A-A in FIG. 16, of a solid-state image pickup device according to a first embodiment of the present invention. Though not shown, in the solid-state image pickup device, pixels PXL are disposed in a pixel region PXR in amatrixmanner, and pixel control circuits (a vertical driver circuit and a horizontal driver circuit) for controlling the pixels, noise removal circuits for removing noise from a signal which is read out from a pixel, amplification circuits for amplifying the signal read out from the pixel, and the like are provided in a peripheral circuitry region PPR outside the pixel region PXR. Each pixel comprises a circuit including a photodiode 1 (hereinafter, referred to as PD 1), a doped region 2, a contact 3, a well sub-wiring 6, a contact 5, a well main-wiring 4. The doped region 2, the contact 3, the well sub-wiring 6, the contact 5, and the well main-wiring 4 are provided for a purpose of controlling a voltage supplied to a well on a semiconductor substrate 7.

For sake of simplicity of description below, one or more wirings for supplying a voltage to the well on the semiconductor substrate are referred to as "a well wiring" or "well wirings" and one or more contacts for supplying a voltage to the well are referred to as "a well contact" or "well contacts".

PD 1 is an element for accumulating a signal charge obtained by photoelectric-converting incident light. Light receiving regions of PD 1 are formed by implanting and diffusing N-type impurity in a well 14 which is formed by implanting and diffusing P-type impurity on a surface of the semiconductor substrate. The doped region 2 is formed by implanting and diffusing P-type impurity in the well 14. Conductivity types of respective sections (the well 14, the PD 1, and the doped region 2) may be reverse to those described above.

A feature of the solid-state image pickup device according to the present invention is that as a principal well wiring, a well main-wiring 4 which is formed in a same process as that in which gates of respective transistors are formed, using a same material as that of the gates of respective transistors, is used. Within the pixel region PXR, a well wiring and a well contact comprise the well main-wiring 4; a wiring layer immediately above the well main-wiring 4, which in other words, is the well sub-wiring 6 of a first wiring layer 10 which is a lowermost wiring layer among metal wiring layers; and contacts 3 and 5 provided in a gate electrode layer 9. No well wiring and no well contact are provided above any of the well sub-wirings (second wiring layer 11) in an entire region where pixels are disposed. In the specification of the present invention, an entire layer between the semiconductor substrate 7 and the first wiring layer 10 is generically referred to as the gate electrode layer 9.

The well main-wiring 4 of the gate electrode layer 9 within the pixel region PXR extends to the peripheral circuitry region PPR outside the pixel region PXR. Outside the pixel region PXR, the well main-wiring 4 is connected via a contact 15, a well wiring 16, and a contact 17 to a well wiring 18 of the second wiring layer 11 which is an uppermost wiring layer. And a voltage in the well 14 within the pixel region PXR is controlled by supplying a reference voltage Vw to the well wiring 18. Outside the pixel region PXR, a reference voltage Vw is supplied via the well wiring 18, the contact 17, the well wiring 16, and a contact 13 to a doped region 12. In light of low power consumption or the like, the reference voltage Vw is preferably a ground voltage (0V).

The lower a layer where a light beamenters is, the smaller a diameter of the light beam collected by a microlens 19 becomes. Therefore, the lower a layer where a light beam enters is, the wider an area of a region where light does not enter, i.e., an area of a region where light is not shut out even with a wiring provided, is. Thus, when a well wiring is provided in a lower layer, an amount of light received by PD 1 is easily ensured as compared with a case where a well wiring is provided in an upper layer. Hence, the solid-state image pickup device according to the present invention can suppress shading and curb a reduction in the amount of light received, thereby attaining a high-quality image.

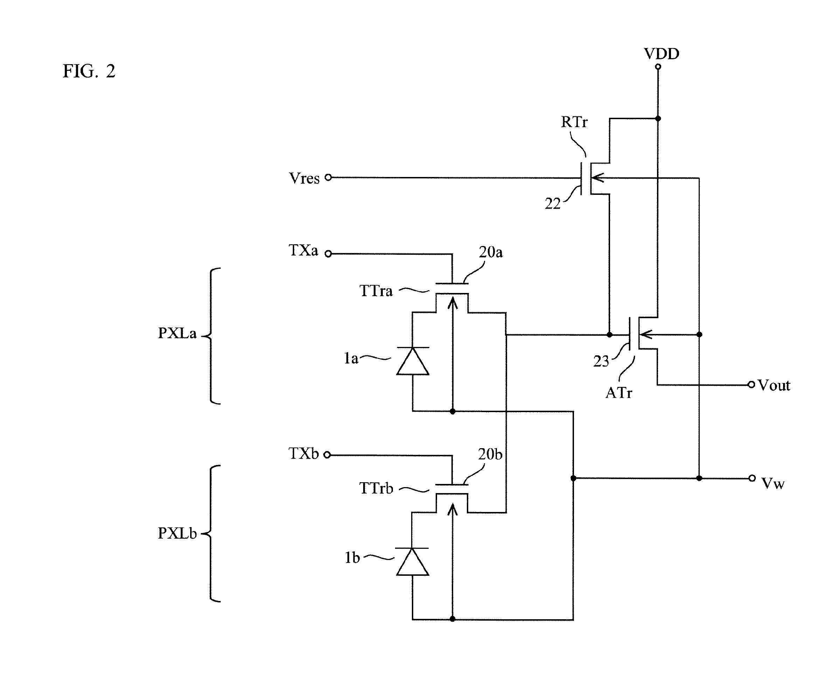

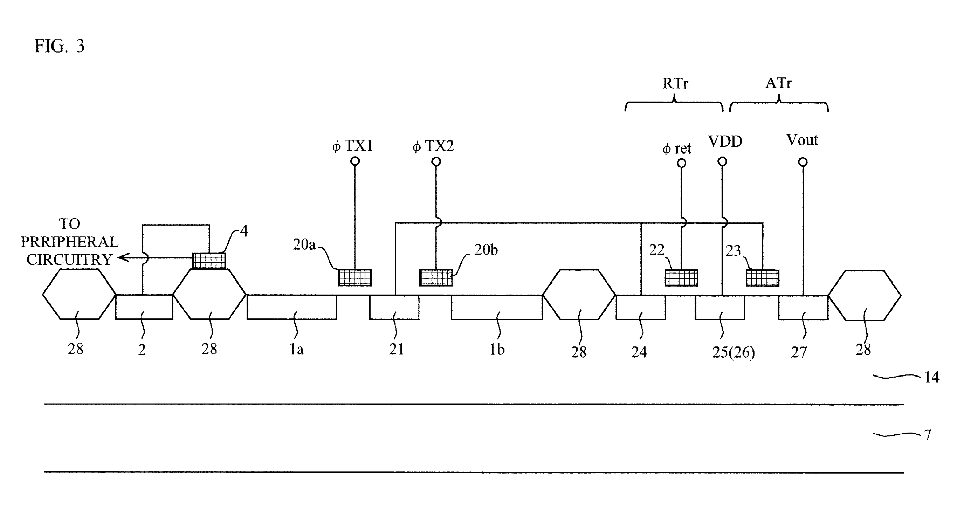

FIG. 2 shows an example of a circuit diagram of pixels in a MOS-type solid-state image pickup device, in which a pair of adjacent two pixels PXLa and PXLb shares a part of circuits. FIG. 3 is a schematic diagram illustrating a view in which the two adjacent pixels PXLa and PXLb are formed in the semiconductor substrate 7. The pixel PXLa has PD 1a and a transfer gate 20a which form a part of a transfer transistor TTra and the pixel PXLb has PD 1b and a transfer gate 20b which form a part of a transfer transistor TTrb. The pixels PXLa and PXLb share an amplification transistor ATr and a reset transistor RTr. In FIG. 3, source drain regions 24, 25(26), and 27 of the amplification transistor ATr and the reset transistor RTr are formed by implanting and diffusing N-type impurity in the well 14.

Charges generated in PDs 1a and 1b are transferred to FD 21 when a predetermined voltage is applied to the transfer gates 20a and 20b. And a voltage in accordance with a charge amount accumulated in FD 21 is applied to an amplification gate 23 of the amplification transistor ATr. The amplification transistor ATr which is used as a source follower circuit outputs onto a vertical signal line a voltage Vout which is obtained by amplifying a reference voltage VDD in accordance with the voltage applied to the amplification gate 23. After a signal has been outputted from a pixel, the reset transistor RTr discharges externally the signal charge accumulated in FD 21 and FD 21 is in an initial state until next signal output.

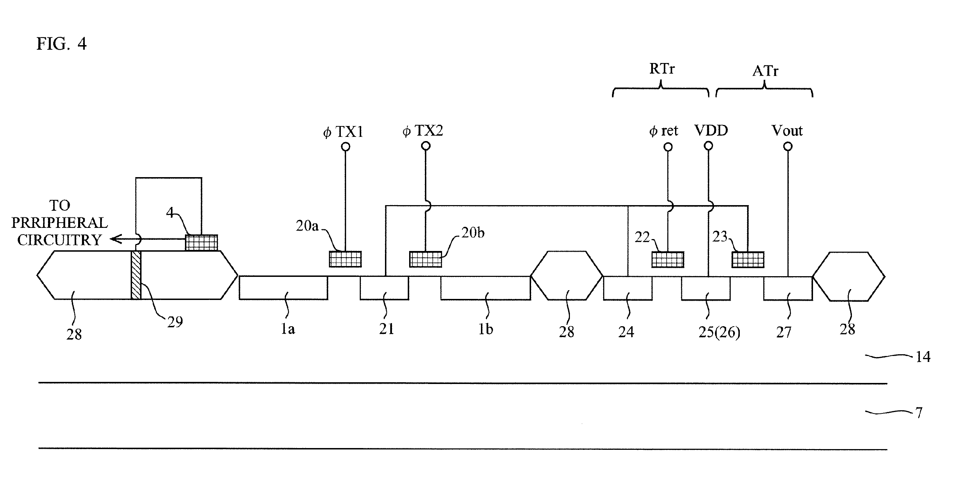

The well main-wiring 4 shown in FIG. 3 is formed in a same process as that in which the transfer gates 20a and 20b, the reset gate 22, and the amplification gate 23 are formed, using a same material as that of the transfer gates 20a and 20b, the reset gates 22, and the amplification gate 23. More specifically, the well main-wiring 4, the transfer gates 20a and 20b, the reset gate 22, and the amplification gate 23 are formed by pattern-etching a thin film which has high conductivity, such as a polysilicon thin film. The well main-wiring 4 may be formed directly on an isolation region 28 which is STI or LOCOS, or may be formed via an isolation film, which is not shown, on the isolation region 28. In the solid-state image pickup device, a contact 29 may be provided so as to penetrate through the isolation region 28 as shown in FIG. 4 or the contact 29 may be directly connected to the well 14 without providing the doped region 2.

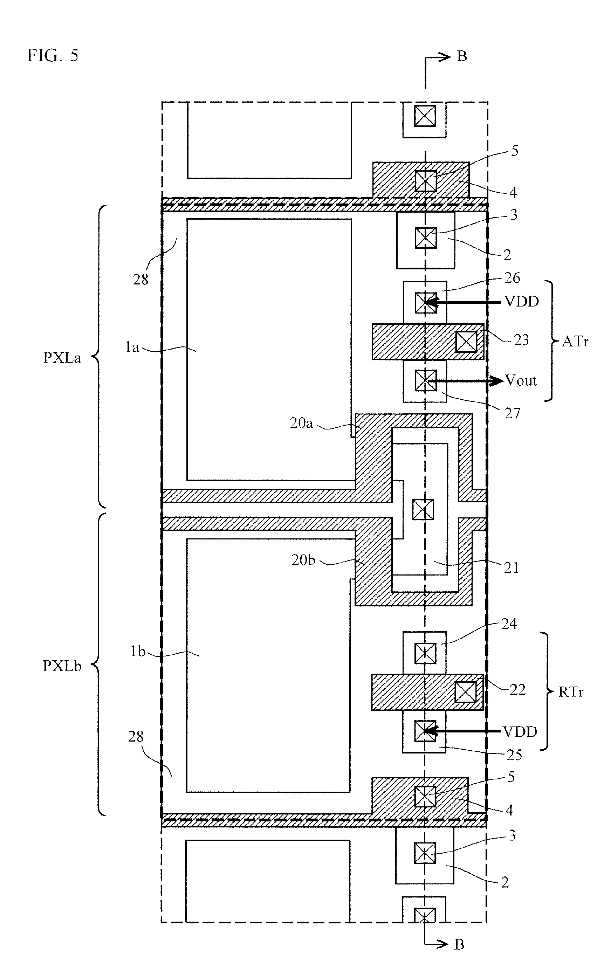

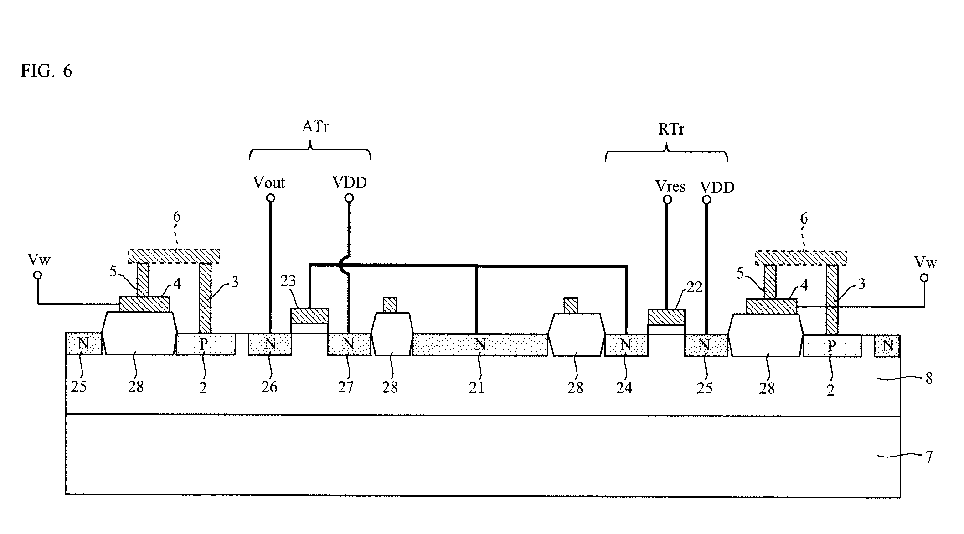

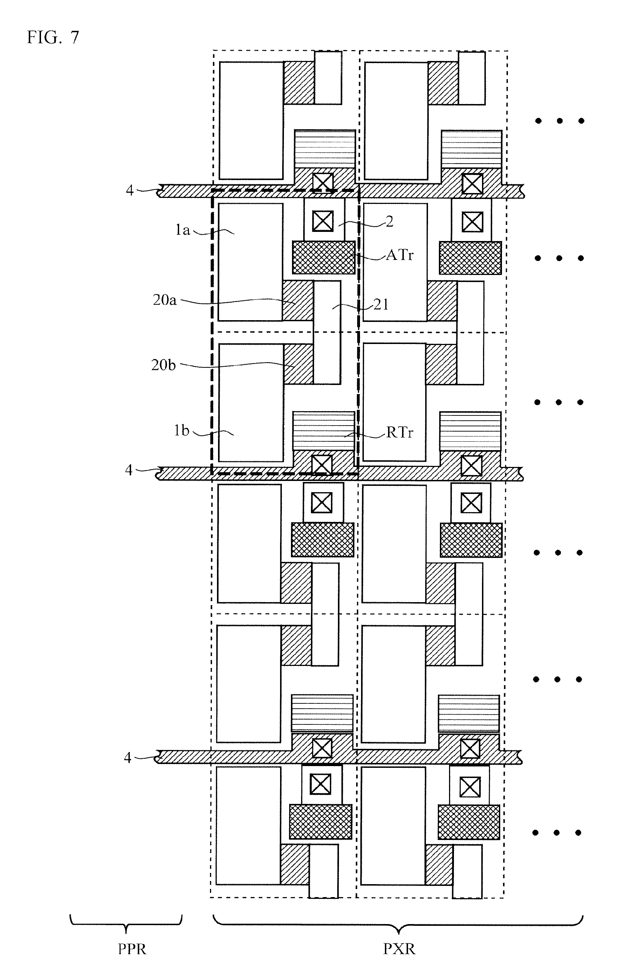

FIG. 5 shows an example of a specific plane layout of circuits shown in FIG. 3. FIG. 6 shows a cross-sectional view along a line B-B shown in FIG. 5. FIG. 7 shows a plane layout in which pixel pairs shown in FIG. 5 are disposed in the pixel region PXR in a matrix manner.
Each of PDs 1a and 1b, the transfer gates 20a and 20b, and FD 21 has an outer shape of a rectangle whose long side is a line extending in a column direction. A pair of PDs 1a and 1b, the transfer gates 20a and 20b, and FD 21 are disposed in order in a row direction. Disposition of PDs 1a and 1b, the transfer gates 20a and 20b, FD 21 is axisymmetrical between the two pixels included in the pair. And FD 21, source drain regions 24 and 25 of the reset transistor RTr, and source drain regions 26 and 27 of the amplification transistor ATr are disposed substantially on a straight line extending a column direction. The well main-wiring 4 is provided for each n (=2) rows and in more detail, extends on an edge (boundary) of the pixel pair in a row direction. The doped region 2 and the contact 3 are provided in one (PXLa) of the two pixels PXLa and PXLb included in the pair. The doped region 2 is provided adjacent to the well main-wiring 4.

Although the source drain regions 24 and 25 of the reset transistor RTr, the reset gate 22, the source drain regions 26 and 27 of the amplification transistor ATr, the amplification gate 23 are disposed in a column direction as shown in FIG. 5, the source drain regions 24 and 25 of the reset transistor RTr, the reset gate 22, the source drain regions 26 and 27 of the amplification transistor ATr, the amplification gate 23 may be disposed in a row direction. Although the transfer gates 20a and 20b and the wirings connected thereto are formed in an integrated manner, the wirings connected thereto may be formed in a metal wiring layer.

In the solid-state image pickup device according to the present invention, wirings which are formed in the same process as that in which the gates of the transistors are formed, using the same material as that of the gates of the transistors, are used for the well main-wirings. In the pixel region PXR, the well main-wirings 4 are mainly used and the well sub-wirings are used only at portions connecting to the doped regions 2 which cannot be directly connected to the well main-wirings 4. Thus, when the wirings in the lower layers are used, a large amount of light received by PD 1 is easily ensured as compared with a case where the well wirings are provided in the upper layers, whereby the shading is suppressed and the reduction in the amount of light received can be curbed, attaining a high-quality image. Hence, the solid-state image pickup device according to the present invention can comprise the well contacts and the well wirings for supplying the reference voltage to the well and even when the area of the pixel is reduced, can suppress the reduction in the amount of light received.

Although as stated above, an active-type MOS-type solid-state image pickup device comprising the amplification transistor ATr provided in the pixel is described as an example, a concept of the present invention is applicable to a passive-type MOS-typesolid-state image pickup device and a CCD-typesolid-state image pickup device. Sharing of the amplification transistor ATr and the reset transistor RTr by a plurality of pixels is effective to reduce an area of the pixel region PXR. However, the amplification transistor ATr and the reset transistor RTr may be provided for each pixel.

### (second embodiment)

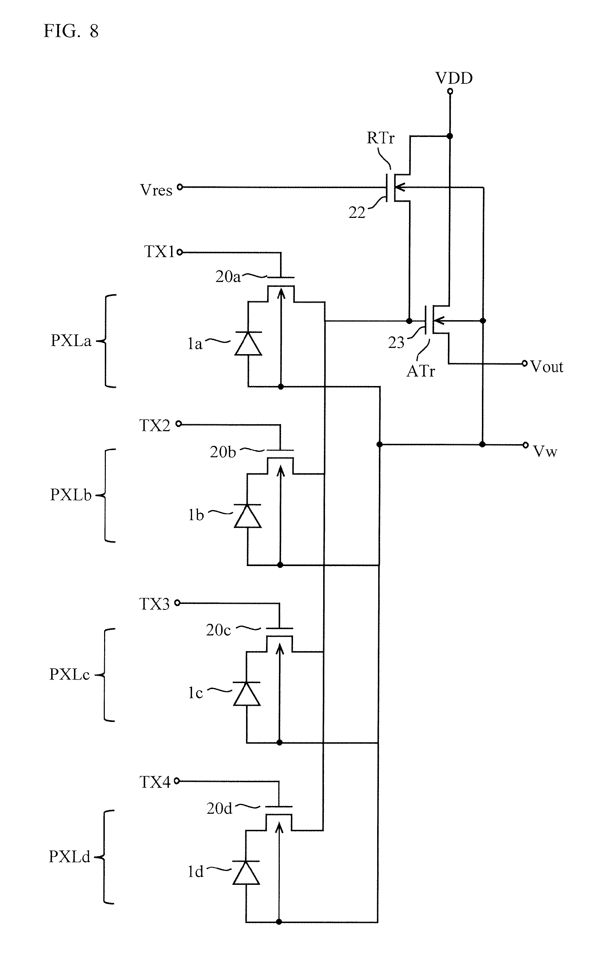

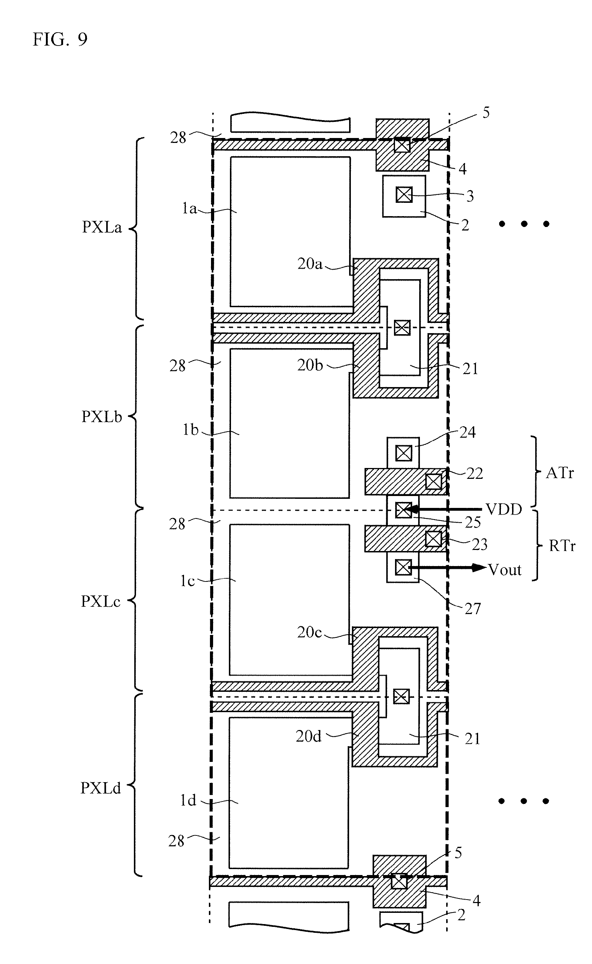

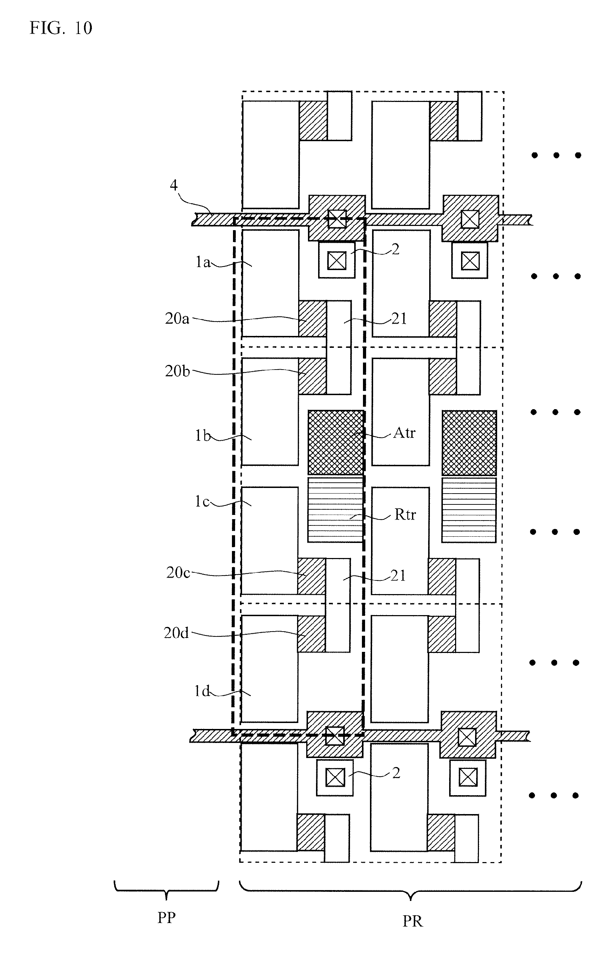

FIG. 8 is a circuit diagram illustrating a specific example of a combination of four pixels PXLa, PXLb, PXLc, and PXLd in a solid-state image pickup device according to a second embodiment of the present invention. FIG. 9 shows a specific example of a layout of circuits shown in FIG. 8. FIG. 10 shows a layout of a pixel region PXR where the combination of the pixels shown in FIG. 9 is disposed in a matrix manner. In specification of the present embodiment, in order to facilitate understanding, same reference numerals as those used for describing common components in the first embodiment are used with description omitted and only feature points are described.

In the solid-state image pickup device according to the present embodiment, PD1a, PD1b, PD1c, and PD1d as well as transfer gates 20a, 20b, 20c, and 20d are provided for the pixels PXLa, PXLb, PXLc, and PLXd, respectively. On the other hand, the combination of the four pixels PXLa, PXLb, PXLc, and PLXd share an amplification transistor ATr and a reset transistor RTr. A well main-wiring 4 is provided for each n (=4) rows and in more detail, extends on an edge (boundary) of the combination of the pixels in a row direction. A doped region 2 and a contact 3 are provided in one (PXLa) of the four pixels PXLa, PXLb, PXLc, and PXLd included in the combination. The doped region 2 is provided adjacent to the well main-wiring 4. The amplification transistor ATr and the reset transistor RTr are provided in 2 middle pixels (PXLb and PXLc) among the four pixels (PXLa, PXLb, PXLc, and PXLd) . The amplification transistor ATr and the reset transistor RTr may share a region 25 as shown in FIG. 9, or may not share the region 25. The amplification transistor ATr and the reset transistor RTr may be separately provided.

### (third embodiment)

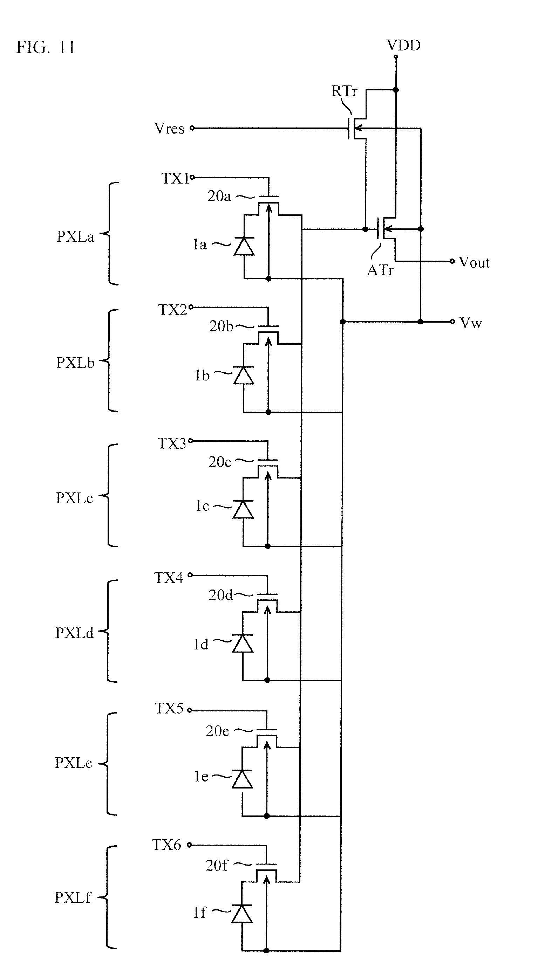

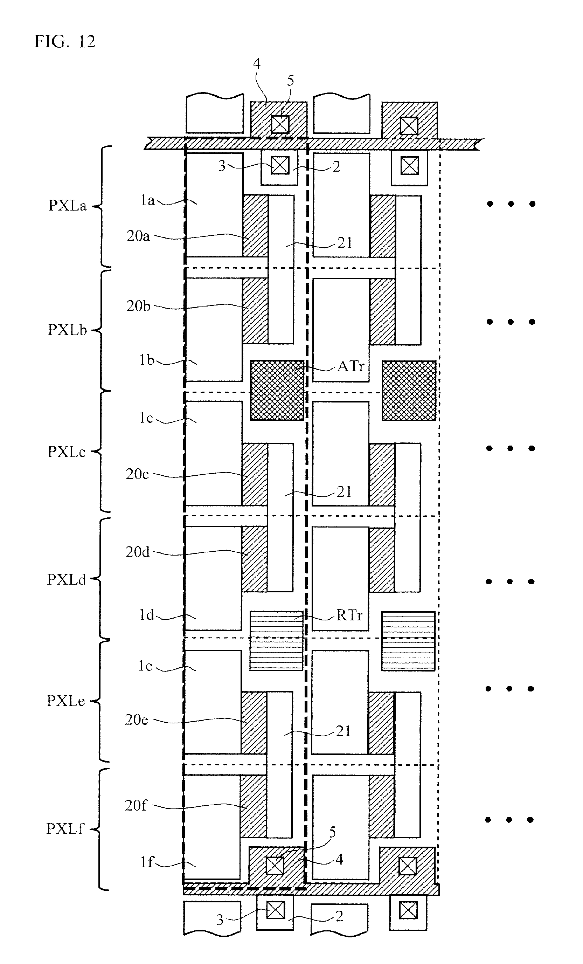

FIG. 11 is a circuit diagram illustrating a specific example of a combination of six pixels PXLa, PXLb, PXLc, PXLd, PXLe, and PXLf in a solid-state image pickup device according to a third embodiment of the present invention. FIG. 12 shows a layout of a pixel region PXR where the combination of the pixels shown in FIG. 11 is disposed in a matrix manner. In specification of the present embodiment, in order to facilitate understanding, same reference numerals as those used for describing common components in the first embodiment are used with description omitted and only feature points are described.

In the solid-state image pickup device according to the present embodiment, PD1a, PD 1b, PD 1c, PD 1d, PD 1e, and PD 1f as well as transfer gates 20a, 20b, 20c, 20d, 20e, and 20f are provided for the pixels PXLa, PXLb, PXLc, PLXd, PLXe, and PLXf, respectively. On the other hand, the combination of the six pixels PXLa, PXLb, PXLc, PLXd, PLXe, and PLXf share an amplification transistor ATr and a reset transistor RTr.

A well main-wiring 4 is provided for each n (=6) rows and in more detail, extends on an edge (boundary) of the combination of the pixels in a row direction. A doped region 2 and a contact 3 are provided in one (PXLa) of the six pixels PXLa, PXLb, PXLc, PXLd, PXLe, and PXLe included in the combination. The doped region 2 is provided adjacent to the well main-wiring 4. The amplification transistor ATr and the reset transistor RTr are provided in four middle pixels PXLb, PXLc, PXLd, and PXLe among the six pixels included in the combination.

### (fourth embodiment)

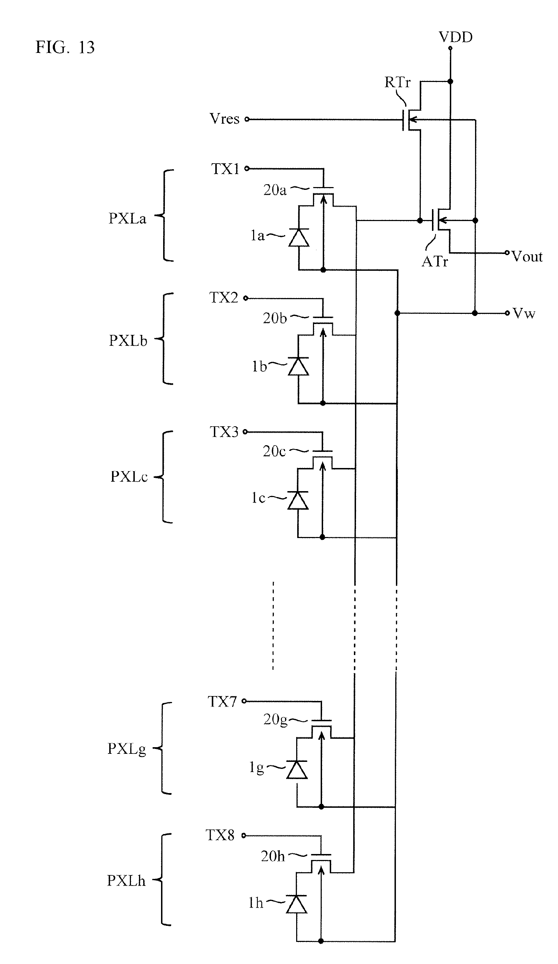

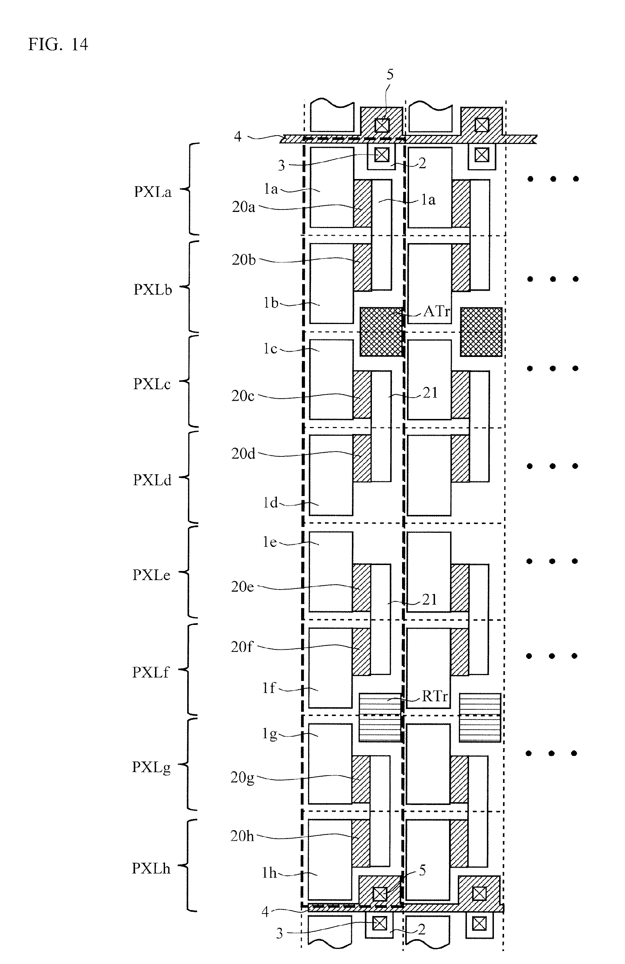

FIG. 13 is a circuit diagram illustrating a specific example of a combination of eight pixels PXLa, PXLb, PXLc, PXLd, PXLe, PXLf, PXLg, and PXLh in a solid-state image pickup device according to a fouth embodiment of the present invention. FIG. 14 shows a layout of a pixel region PXR where the combination of the pixels shown in FIG. 13 is disposed in a matrix manner. In specification of the present embodiment, in order to facilitate understanding, same reference numerals as those used for describing common components in the first embodiment are used with description omitted and only feature points are described.

In the solid-state image pickup device according to the present embodiment, PD 1a, PD 1b, PD 1c, PD 1d, PD 1e, PD 1f, PD1g, and PD 1h as well as transfer gates 20a, 20b, 20c, 20d, 20e, 20f, 20g, and 20h are provided for the pixels PXLa, PXLb, PXLc, PLXd, PLXe, PLXf, PLXg, andPLXh, respectively. On the other hand, the combination of the eight pixels PXLa, PXLb, PXLc, PLXd, PLXe, PLXf PLXg, and PLXh share an amplification transistor ATr and a reset transistor RTr.

A well main-wiring 4 is provided for each n (=8) rows and in more detail, extends on an edge (boundary) of the combination of the pixels in a row direction. A doped region 2 and a contact 3 are provided in one (PXLa) of the eight pixels PXLa, PXLb, PXLc, PXLd, PXLe, PXLf, PXLg, and PXLh included in the combination. The doped region 2 is provided adjacent to the well main-wiring 4. The amplification transistor ATr is provided substantially between the pixels PXLb and PXLc. The reset transistor RTr is provided substantially between the pixels PXLf and PXLg.

The present invention is applicable to a solid-state image pickup device which can be used in a variety of apparatuses such as a digital still camera and a digital video camera, in which a MOS-type or a CCD-type image sensor is mounted.

While the invention has been described in detail, the foregoing description is in all aspects illustrative and not restrictive. It is understood that numerous other modifications and variations can be devised without departing from the scope of the invention.

## Claims

1. A solid-state image pickup device including a pixel region (PXR) and a peripheral circuitry region (PPR) on a semiconductor substrate (7) having a well region (14) of a first conductivity type, comprising:
a plurality of photodiodes (1) of a second conductivity type, which are provided in the well region;
a plurality of floating diffusions (21) of the second conductivity type, which are provided in the well region;
a plurality of transfer gates (20) provided for each of the photodiodes on the semiconductor substrate; and
a plurality of well main-wirings (4) formed on a same layer as that on which the transfer gates are formed, wherein
a reference voltage is supplied via the well main-wirings from the peripheral circuitry region to the well region within the pixel region.

2. The solid-state image pickup device according to claim 1, wherein the pixel region further comprises:
a plurality of well sub-wirings (6) provided in a lowermost layer (10) among a plurality of metal wiring layers (10, 11) ;
a plurality of first contacts (5) for connecting the well main-wirings and the well sub-wirings; and
a plurality of second contacts (3) for connecting the well sub-wirings and the well region.

3. The solid-state image pickup device according to claim 2, wherein the well region having the first contacts connected thereto further comprises a doped region (2) of the first conductivity type.

4. The solid-state image pickup device according to claim 2, wherein the peripheral circuitry region further comprises a plurality of third contacts (13) for connecting the well main-wirings and the well region.

5. The solid-state image pickup device according to claim 2, wirings (18) provided in an uppermost layer (11) among the plurality of the metal wiring layers are connected to the well main-wirings only in the peripheral circuitry region.

6. The solid-state image pickup device according to claim 1, wherein each of the well main-wirings is provided for each n rows, where n is an even number.

7. The solid-state image pickup device according to claim 6, further comprising
a plurality of reset transistors (RTr), each of which is shared by a combination of n pixels adj acent in a column direction, wherein
the well main-wirings extend on an edge of the combination of the pixels in a column direction.

8. The solid-state image pickup device according to claim 7, wherein each of the plurality of second contacts is provided on a first or nth pixel of n pixels adjacent in a column direction.
